# EUROPEAN PATENT APPLICATION

(11) **EP 4 679 967 A1**
(43) Date of publication of application: **14.01.2026**
(21) Application number: 24767211.6
(22) Date of filing: 07.03.2024
(51) Int. Cl.: H10B 61/00, H01F 10/14, H10N 52/80, H10N 52/85

(54) **MAGNETIC MEMORY ELEMENT AND METHOD FOR WRITING AND READING INFORMATION TO AND FROM MAGNETIC MEMORY ELEMENT**

(30) Priority: 07.03.2023 JP 2023034780
(71) Applicant: INSTITUTE OF SCIENCE TOKYO, Tokyo 152-8550 (JP); KANAGAWA INSTITUTE OF INDUSTRIAL SCIENCE AND TECHNOLOGY, Ebina-shi Kanagawa 243-0435 (JP); Sumitomo Chemical Company, Limited, Tokyo 103-6020 (JP)
(72) Inventor: AZUMA Masaki, Tokyo 152-8550 (JP); SHIGEMATSU Kei, Tokyo 152-8550 (JP); ITOH Takuma, Tokyo 152-8550 (JP)
(74) Representative: Meissner Bolte Nürnberg
(86) International application number: PCT/JP2024/008729
(87) International publication number: WO 2024/185845

(57) **Abstract**

A magnetic memory element includes: a thin film that is composed of a compound represented by Formula (1) below; a first electrode that is arranged on the thin film; and a second electrode that is arranged on the thin film.

BiFe₁₋ₓAₓO₃ (1)

where A represents Co or Mn and x satisfies 0.05 ≤ x < 0.25 in Formula (1).

The first electrode and the second electrode are arranged such that an electric field is generated in the thin film in a direction parallel to the thin film when voltage is applied between the first electrode and the second electrode.

## Description

### TECHNICAL FIELD

The present invention relates to a magnetic memory element and a method for writing and reading information to and from the magnetic memory element.

### BACKGROUND ART

BiFe_{0.9}Co_{0.1}O₃, which is partially substituted with Co for Fe of BiFeO₃, has both ferroelectric and weak ferromagnetic properties at room temperature, and magnetization reversal associated with 71° polarization reversal has been observed using a magnetic force microscope (MFM). Thus, application to ultra-low-consumption magnetic memory using this magnetization reversal phenomenon caused by the application of an electric field is expected (Non-Patent Literature 1). Magnetization reversal is also expected in 109° polarization reversal (Non-Patent Literature 2).

### RELATED-ART LITERATURE

### PATENT LITERATURE

Non-Patent Literature 1: K. Shimizu, et al., Nano Lett. 19, 1767 (2019)
Non-Patent Literature 2: J. T. Heron, et al., Nature 516, 370 (2014)

### SUMMARY OF INVENTION

### TECHNICAL PROBLEM

However, although magnetization reversal is expected to occur even at 109° polarization reversal in Non-Patent Literature 2, the details thereof are unclear. Clarification of this behavior is believed to be able to accelerate the application of magnetic memory elements greatly.

The present invention has been made in view of such a situation, and one of exemplary objects thereof is to provide a magnetic memory element to and from which information can be written and read by an electric field.

### SOLUTION TO PROBLEM

A magnetic memory element according to an embodiment of the present invention includes: a thin film that is composed of a compound represented by Formula (1) below; a first electrode that is arranged on the thin film; and a second electrode that is arranged on the thin film.

BiFe₁₋ₓAₓO₃ (1)

where A represents Co or Mn and x satisfies 0.05 ≤ x < 0.25 in Formula (1).

The first electrode and the second electrode are arranged such that an electric field is generated in the thin film in a direction parallel to the thin film when voltage is applied between the first electrode and the second electrode.

Another embodiment of the present invention relates to a method for writing and reading information to and from the magnetic memory element. The method for writing and reading information to and from the magnetic memory element includes: applying voltage between the first electrode and the second electrode of the magnetic memory element so as to reverse the magnetization of the thin film and write information; and detecting the reversal of the magnetization of the thin film so as to read the written information.

Optional combinations of the aforementioned constituting elements, and implementations of the present disclosure in the form of methods, apparatuses, and systems may also be practiced as additional modes of the present disclosure.

### ADVANTAGEOUS EFFECTS OF INVENTION

According to the present invention, it is possible to provide a magnetic memory element to and from which information can be written and read by an electric field.

### BRIEF DESCRIPTION OF DRAWINGS

[Fig. 1] Fig. 1 is a schematic diagram of a magnetic memory element according to an embodiment of the present invention.
[Fig. 2] Fig. 2(a) is a diagram showing the crystal structure and magnetic structure of BiFeO₃. Fig. 2(b) is a diagram showing the crystal structure and magnetic structure of BiFe₁₋ₓAₓO₃.
[Fig. 3] Fig. 3 is a diagram for explaining spontaneous polarization that can be achieved by BiFe₁₋ₓAₓO₃ and a polarization reversal thereof.
[Fig. 4] Fig. 4 is a diagram for explaining the detailed configuration of an electrode portion.
[Fig. 5] Fig. 5(a) to Fig. 5(d) are diagrams for explaining an example of a method for producing a magnetic memory element according to an embodiment of the present invention.
[Fig. 6] Fig. 6 is a diagram schematically showing the upper surface of a sample according to an exemplary embodiment.
[Fig. 7] Fig. 7(a) is a diagram showing the result of observing a ferroelectric domain when a voltage of +80 V was applied, Fig. 7(b) is a diagram showing the result of observing a ferroelectric domain when a voltage of -80 V was applied, Fig. 7(c) is a diagram showing the result of observing a ferromagnetic domain when a voltage of +80 V was applied, and Fig. 7(d) is a diagram showing the result of observing a ferromagnetic domain when a voltage of -80V was applied.

### DESCRIPTION OF EMBODIMENTS

### (Background)

In magnetic memory such as hard disk drive (HDD) and magnetoresistive random access memory (MRAM), magnetic information is written by controlling the magnetization of ferromagnetic materials with a magnetic field generated by passing a current through a coil. Therefore, an increase in the amount of information poses the problem of increased power consumption. Furthermore, ferroelectric random memory such as FeRAM requires information to be destroyed once when reading the information and then writing the information again after the reading. Therefore, a technology is needed that suppresses an increase in power consumption that comes with an increase in the amount of information and does not require the destruction of information when reading the information. Therefore, there are high expectations for a technology that uses magnetization reversal caused by the application of an electric field using ferromagnetic ferroelectrics (multiferroic materials) to write information using an electric field and read information using magnetism.

### (Embodiment)

Hereinafter, an embodiment for carrying out the present invention will be described in detail with reference to the accompanying drawing. In the explanation of the figures, like numerals represent like constituting elements, and duplicative explanations will be omitted appropriately. Further, the configuration mentioned below is merely an example, and does not limit the scope of the invention.

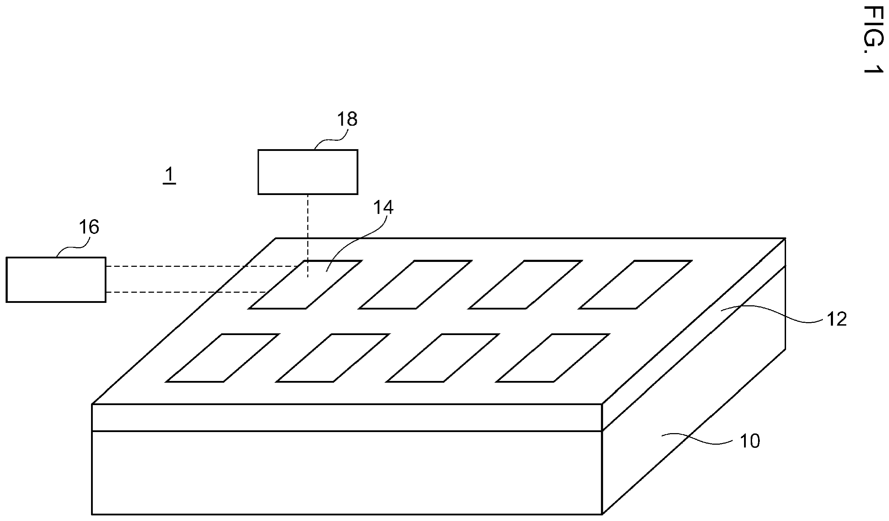

Fig. 1 is a schematic diagram of a magnetic memory element 1 according to an embodiment of the present invention. The magnetic memory element 1 includes a substrate 10, a thin film 12, a plurality of electrode portions 14, a power supply 16, and a reading unit 18. In Fig. 1, the power supply 16 is for applying voltage to each electrode portion 14. Further, although Fig. 1 shows eight electrode portions 14, the number of electrode portions may be less than seven or may be nine or more.

The substrate 10 may be composed of a compound having a perovskite structure and a lattice constant of, for example, 3.90 to 3.97Å in pseudo-cubic notation. The substrate 10 may be, for example, a SrTiO₃ substrate, a GdScO₃ substrate, a TbScO₃ substrate, or a DyScO₃ substrate. The substrate 10 may be a (110)-oriented substrate in the case of a SrTiO₃ substrate and a (010)-oriented substrate in the case of a GdScO₃ substrate, a TbScO₃ substrate or a DyScO₃ substrate. The thickness of the substrate 10 is not particularly limited; however, from the viewpoint of thin film synthesis and ease of handling, the thickness is preferably 300 µm to 1000 µm and is more preferably 400 µm to 600 µm.

The thin film 12 is composed of a compound represented by Formula (1) below.

BiFe₁₋ₓAₓO₃ (1)

In Formula (1), A represents Co or Mn, and x satisfies 0.05 ≤ x < 0.25.
When x is 0.05 or higher, the thin film 12 can exhibit ferromagnetic and ferroelectric properties at room temperature. When x is less than 0.25, the change in the crystal structure of the thin film 12 can be suppressed. The magnitude of spontaneous magnetization of the thin film 12 at room temperature may be about 1 emu/cm³ to 10 emu/cm³, and the magnitude of spontaneous polarization may be about 50 to 150 µC/cm².

The thickness of the thin film 12 is preferably 10 nm to 1000 nm. Such a thickness of the thin film 12 makes it possible to reliably apply an electric field to the thin film 12, which can improve the reliability of the magnetic memory element 1 as a device. From the viewpoint of lattice distortion, the thickness of the thin film 12 is preferably 30 nm to 400 nm. Setting the thickness of thin film 12 to 30 nm or more allows the stripe domain of the thin film 12 to be stabilized.

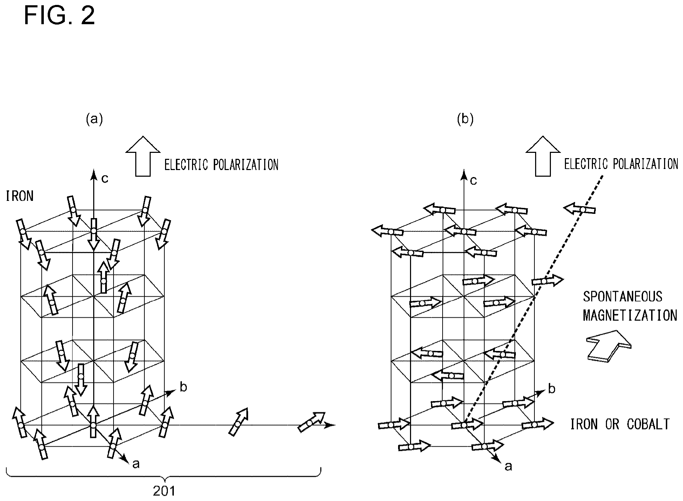

Referring to Fig. 2(a) and Fig. 2(b), the spontaneous magnetization and spontaneous polarization of BiFe₁₋ₓAₓO₃ will be described. Fig. 2(a) is a diagram showing the crystal structure and magnetic structure of BiFeO₃. Fig. 2(b) is a diagram showing the crystal structure and magnetic structure of BiFe₁₋ₓAₓO₃.

BiFeO₃ has a hexagonal crystal structure in which layers containing iron sites with spin magnetic moments (hereinafter also simply referred to as "spin") indicated by arrows are stacked in the c-axis direction. BiFeO₃ has electric polarization (spontaneous polarization) in the c-axis direction. As shown in Fig. 2(a), each iron site has a spin that is opposite to the spin of the nearest iron site in an adjacent layer in the c-axis direction. Furthermore, iron sites that are aligned in a straight line in an ab-plane (for example, five iron sites 201 shown in Fig. 2(a)) form a cycloid. In this cycloid, one full rotation of the spin occurs at 620 Å. Therefore, BiFeO₃ does not have spontaneous magnetization.

BiFe₁₋ₓAₓO₃ is a BiFeO₃ alloy in which some of the Fe are replaced with A. Just like BiFeO₃, BiFe₁₋ₓAₓO₃ has a hexagonal crystal structure in which layers containing iron or cobalt sites with spin are stacked in the c-axis direction. Further, BiFe₁₋ₓAₓO₃ has electric polarization (spontaneous polarization) in the c-axis direction. Unlike BiFeO₃, the spin in BiFe₁₋ₓAₓO₃ is oriented toward the ab-plane. Further, in Fig. 2(b), the spin of two layers adjacent to each other in the c-axis direction arranged on a dashed line is tilted such that spontaneous magnetization occurs in the ab-plane. As a result, BiFe₁₋ₓAₓO₃ exhibits weak ferromagnetism. Thus, BiFe₁₋ₓAₓO₃ has spontaneous polarization in the c-axis direction and spontaneous magnetization perpendicular to the spontaneous polarization.

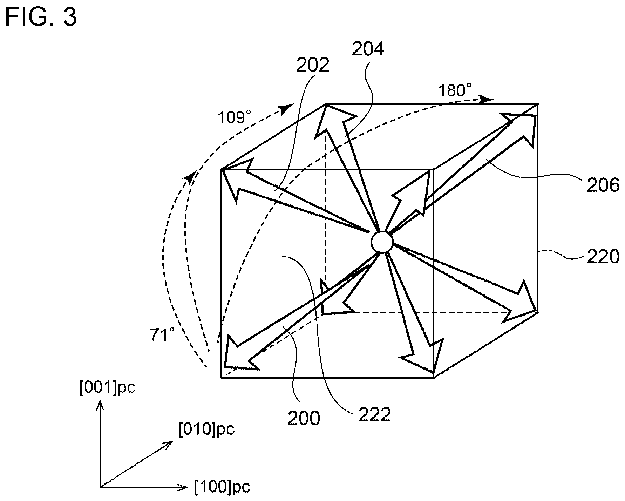

Fig. 3 is a diagram for explaining spontaneous polarization that can be achieved by BiFe₁₋ₓAₓO₃ and a polarization reversal thereof. In Fig. 3, the crystal structure of BiFe₁₋ₓAₓO₃ is shown as a pseudo-cubic crystal. The eight arrows in the cubic crystal indicate the possible directions of spontaneous polarization in BiFe₁₋ₓAₓO₃. By applying an electric field to BiFe₁₋ₓAₓO₃, the direction of spontaneous polarization in BiFe₁₋ₓAₓO₃ can be changed. More specifically, spontaneous polarization 200 can be reversed by 71°, 109°, or 180°.

For example, the spontaneous polarization 200 can be changed to spontaneous polarization 202 in the direction toward the other end of a side 220 that is shared (71° polarization reversal). Further, the spontaneous polarization 200 can be changed to spontaneous polarization 204 in the direction toward the other diagonal end of a side 222 that is shared (109° polarization reversal). Further, the spontaneous polarization 200 can be changed to spontaneous polarization 206 oriented in the opposite direction (180° polarization reversal). When the spontaneous polarization 200 undergoes a polarization reversal, the direction of spontaneous magnetization also reverses.

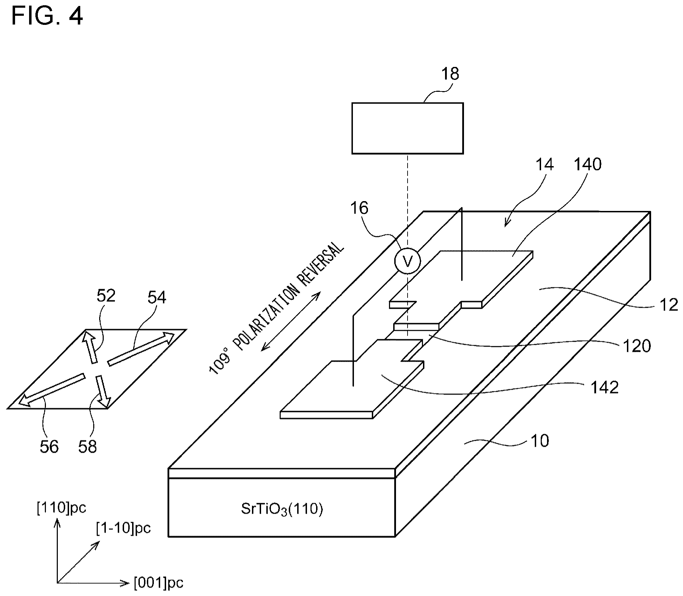

Fig. 4 is a diagram for explaining the detailed configuration of an electrode portion 14. As shown in Fig. 4, the electrode portion 14 has a first electrode 140 and a second electrode 142. The material constituting the first electrode 140 and the second electrode 142 is not particularly limited, and may be a metal such as platinum, for example.

The [110] direction of the thin film 12 is the direction perpendicular to the surface of the thin film 12, the [001] and [1-10] directions of the thin film 12 are in-plane directions of the thin film 12, and the [001] and [1-10] directions are directions perpendicular to each other. Fig. 4 shows the directions of four types of possible spontaneous polarization (first polarization 52, second polarization 54, third polarization 56, and fourth polarization 58) that the thin film 12 can have in the in-plane direction (direction parallel to the thin film 12).

In this embodiment, the first electrode 140 and the second electrode 142 are arranged such that an electric field is generated in the [1-10] direction of the thin film 12. More specifically, the first electrode 140 and the second electrode 142 are arranged so as have a gap in the [1-10] direction. This allows the electric field to more reliably change the spontaneous polarization of the thin film 12 and write information to the magnetic memory element 1.

The first electrode 140 and the second electrode 142 may be formed on the upper surface of the thin film 12 by vapor deposition. An electric field region 120 is formed in the thin film 12 between the first electrode 140 and the second electrode 142. When voltage is applied between the first electrode 140 and the second electrode 142 from the power supply 16, an electric field is generated in the electric field region 120 in a direction parallel to the [1-10] direction. In response to this electric field, the spontaneous polarization and spontaneous magnetization of the electric field region 120 are reversed, allowing information to be written to the electric field region 120.

The information written in the electric field region 120 is read by the detection of a reversal of magnetization in the electric field region 120 by the reading unit 18 arranged above the electric field region 120. The reading unit 18 contains a sensor that is processed to a size equal to or smaller than the magnetic domain and can detect magnetization reversals. Such sensors include, for example, a Hall element and a magnetoresistive element.

Thus, according to the present embodiment, a magnetic memory element to and from which information can be written and read by an electric field can be provided. Further, since the magnetic memory element 1 according to the present embodiment has a configuration in which two electrodes (the first electrode 140 and the second electrode 142) are formed at positions spaced apart in the in-plane direction, short circuits between the electrodes can be suppressed more than a case where the two electrodes are arranged being spaced apart in the direction perpendicular to the surface. Since short circuits can be suppressed, it is also possible to make the thin film 12 thinner.

### (Method for producing magnetic memory element)

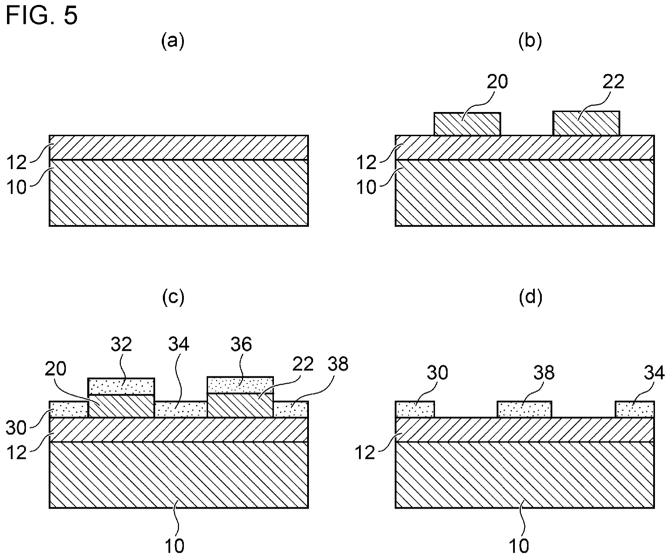

Referring to Fig. 5(a) to Fig. 5(d), an example of a method for producing a magnetic memory element according to an embodiment of the present invention will be described.

First, a thin film 12 is formed on the substrate 10 (Fig. 5(a)). The formation method of the thin film 12 is not particularly limited and may be any of various known methods such as physical vapor deposition (PVD method) and chemical vapor deposition (CVD method). Specific examples of the PVD method include a pulsed laser deposition (PLD) method and a sputtering method. Specific examples of the CVD method include an organometallic (MO) CVD method and a mist CVD method.

Then, on the thin film 12, an electrode having a desired pattern is formed. The present embodiment describes an example of forming an electrode by a lift-off method on the thin film 12. However, the method of forming the electrode is not limited to this and may be any of various known methods.

For example, patterned photoresists 20 and 22 are deposited to the thin film 12 (Fig. 5(b)). Then, metal films 30, 32, 34, 36, and 38 are formed on the thin film 12 and the photoresists 20 and 22 (Fig. 5(c)). The film formation method is not particularly limited and may be any of various known methods such as a PVD method and a CVD method. Then, by peeling off the photoresists 20 and 22, an electrode composed of the metal films 30, 34, and 38 with the desired pattern can be formed (Fig. 5(d)). In this way, a magnetic memory element can be produced in which the electrode with the desired pattern is formed on the thin film 12.

### Exemplary Embodiments

Hereinafter, exemplary embodiments of the present invention will be explained. However, these exemplary embodiments are merely examples for suitably explaining the present invention and do not limit the present invention in any way.

In an exemplary embodiment, a BiFe_{0.9}Co_{0.1}O₃ thin film was prepared on a substrate, and an electrode was then formed thereon to produce a sample according to the exemplary embodiment. In the present exemplary embodiment, SrTiO₃ (110 orientation) was selected as the substrate. One side of this substrate was polished, and a BiFe_{0.9}Co_{0.1}O₃ thin film (60 nm thick) was prepared thereon using pulsed laser deposition (PLD) under conditions of an oxygen partial pressure of 15 Pa, a film formation temperature of 667 to 680°C, and a laser fluence of 1.0 J/cm². A platinum electrode with a gap of 1.5 µm was formed on the thin film by lift-off so as to produce a sample.

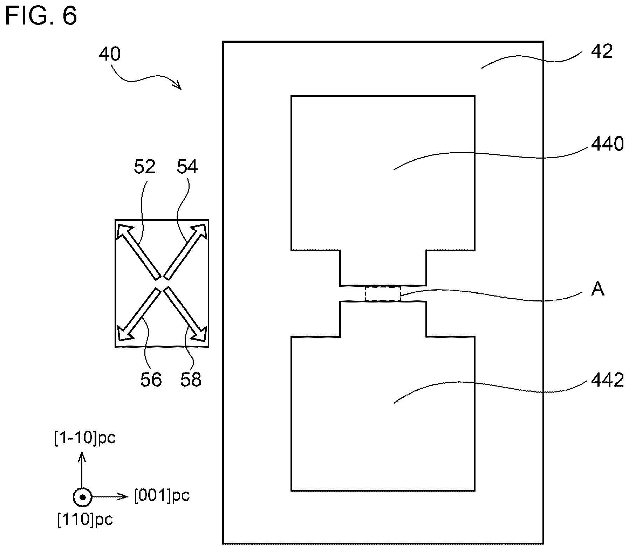

Fig. 6 is a diagram schematically showing the upper surface of a sample 40 according to the present exemplary embodiment. Fig. 6 shows the directions of four types of possible spontaneous polarization (first polarization 52, second polarization 54, third polarization 56, and fourth polarization 58) that a thin film 42 can have in the in-plane direction (direction parallel to the thin film 42). The thin film 42 is (110) oriented. The [001] direction of the thin film 12 is in-plane and is perpendicular to both the [110] direction and the [1-10] direction. In the sample 40 according to the present exemplary embodiment, a first electrode 440 and a second electrode 442 are formed on the thin film 42 so as to have a gap of 1.5 µm in the [1-10] direction of the thin film 42. As a result, when voltage is applied to the first electrode 440 and the second electrode 442, an electric field in the [1-10] direction is generated in the thin film 42 in the gap.

The crystallinity of the formed thin film was evaluated using reciprocal space mapping (RSM) using X-ray diffraction, and it was confirmed that a BiFe_{0.9}Co_{0.1}O₃ thin film was obtained.

To investigate whether there is a correlation between ferroelectricity and ferromagnetism, ferroelectric and ferromagnetic domains were observed using a piezoelectric force microscope (PFM) and a magnetic force microscope (MFM) (Cypher manufactured by Asylum).

Voltage was applied between the first electrode 440 and the second electrode 442, and the ferroelectric and ferromagnetic domains were observed. As mentioned above, spontaneous polarization can occur in four directions within a plane. Therefore, in the PFM measurements, spontaneous polarization was measured in in-plane directions that were 90° apart from one another, and the measurement results for spontaneous polarization in the four directions were obtained by combining these measurement results.

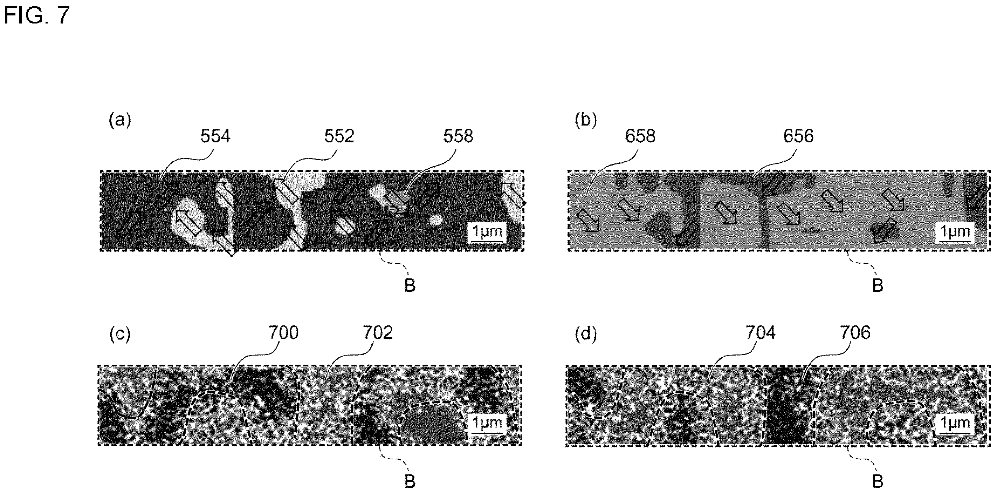

Voltages of 30 V, 60 V, 80 V, and 100 V were applied between the first electrode 440 and the second electrode 442, and polarization reversal was observed when a voltage of 80 V (533 kV/cm) or higher was applied. Figs. 7(a) to 7(d) show the results of observing the ferroelectric or ferromagnetic domain in a part (region B) of a region A shown in Fig. 6 when a voltage of +80 V was applied and then a voltage of -80 V was further applied. Fig. 7(a) is a diagram showing the result of observing a ferroelectric domain when a voltage of +80 V was applied. Fig. 7(b) is a diagram showing the result of observing a ferroelectric domain when a voltage of -80 V was applied after that. Fig. 7(c) is a diagram showing the result of observing a ferromagnetic domain when a voltage of +80 V was applied. Fig. 7(d) is a diagram showing the result of observing a ferromagnetic domain when a voltage of -80V was applied after that.

In Figs. 7(a) and 7(b), the direction of spontaneous polarization in each domain is indicated by an arrow. As shown in Fig. 7 (a), when a voltage of +80 V was applied, a domain 552 of the first polarization 52, a domain 554 of the second polarization 54, and a domain 558 of the fourth polarization 58 were observed in the region B. When the applied voltage was reversed from +80 V to -80 V, a domain 658 of the fourth polarization 58 and a domain 656 of the third polarization 56 were observed in the region B, as shown in Fig. 7(b). Comparing Figs. 7(a) and 7(b), it can be found that by reversing the applied voltage from +80 V to -80 V, the first polarization 52 is reversed by 109° to become the third polarization 56, and the second polarization 54 is reversed by 109° to become the fourth polarization 58. Further, a polarization reversal of 180° is observed in some parts.

In Figs. 7(c) and 7(d), the directions of out-of-plane components of spontaneous magnetization are shown in grayscale, and the directions of the out-of-plane components of the spontaneous magnetization are opposite between dark gray areas and light gray areas. For example, the direction of the out-of-plane components of spontaneous magnetization are opposite between a region 700 in Fig. 7(c) and a neighboring region 702 thereof. Comparing Figs. 7(a) and 7(b), it can be found that the spontaneous magnetization is also reversed by reversing the applied voltage from +80 V to -80 V. For example, the directions of the out-of-plane components of spontaneous magnetization are opposite between the region 700 in Fig. 7(c) and a corresponding region 704 in Fig. 7(d), and the directions of the out-of-plane components of spontaneous magnetization are opposite between the region 702 in Fig. 7(c) and a corresponding region 706 in Fig. 7(d). As described above, in the present exemplary embodiment, a sample was obtained in which the spontaneous polarization and spontaneous magnetization of the sample was able to be reversed by reversing the applied voltage.

Described above is an explanation of the present invention based on the embodiments. These embodiments are intended to be illustrative only, and it will be obvious to those skilled in the art that various modifications to constituting elements and processes could be developed and that such modifications are also within the scope of the present invention.

### INDUSTRIAL APPLICABILITY

The present invention is applicable to a magnetic memory element and a method for writing and reading information to and from the magnetic memory element.

### REFERENCE SIGNS LIST

1 magnetic memory element, 10 substrate, 12 thin film, 14 electrode portion, 16 power supply, 18 reading unit, 20, 22 photoresist, 30, 32, 34, 36, 38 metal film, 52 first polarization, 54 second polarization, 56 third polarization, 58 fourth polarization, 140 first electrode, 142 second electrode, 200, 202, 204, 206, 208 spontaneous polarization, 440 first electrode, 442 second electrode, 552, 554, 558, 656, 658 domain

## Claims

1. A magnetic memory element comprising:
a thin film that is composed of a compound represented by Formula (1) below;
a first electrode that is arranged on the thin film; and
a second electrode that is arranged on the thin film,
wherein the first electrode and the second electrode are arranged such that an electric field is generated in the thin film in a direction parallel to the thin film when voltage is applied between the first electrode and the second electrode.
BiFe₁₋ₓAₓO₃ (1)
where A represents Co or Mn and x satisfies 0.05 ≤ x < 0.25 in Formula (1).

2. The magnetic memory element according to Claim 1,
wherein the thin film is (110) oriented.

3. The magnetic memory element according to Claim 2,
wherein the first electrode and the second electrode are arranged such that an electric field is generated in the [1-10] direction of the thin film.

4. The magnetic memory element according to Claim 1,
wherein the thickness of the thin film is 10 nm to 1000 nm.

5. The magnetic memory element according to Claim 1, further comprising:
a substrate on which the thin film is arranged,
wherein the substrate is a (110)-oriented SrTiO₃ substrate, a (010)-oriented GdScO₃ substrate, a (010)-oriented GdScO₃ substrate, or a (010)-oriented DyScO₃ substrate.

6. A method for writing and reading information to and from the magnetic memory element according to Claim 1, comprising:
applying voltage between the first electrode and the second electrode of the magnetic memory element so as to reverse the magnetization of the thin film and write information; and
detecting the reversal of the magnetization of the thin film so as to read the written information.
